Europäisches Patentamt

European Patent Office

Office européen des brevets

(11) Publication number: **0 302 475**
A1

(12) **EUROPEAN PATENT APPLICATION**

(21) Application number: 88112649.4

(22) Date of filing: 03.08.88

(51) Int. Cl.⁴: **B25J 15/02 , B25J 17/02 ,
B25J 19/02**

(30) Priority: 03.08.87 US 80619

(43) Date of publication of application:
08.02.89 Bulletin 89/06

(84) Designated Contracting States:
AT BE CH DE ES FR GB GR IT LI LU NL SE

(71) Applicant: ALLIANCE AUTOMATION
SYSTEMS, INC.
400 Trabold Road
Rochester New York 14624(US)

(72) Inventor: Farquhar, James J.
1379 Cordelia Avenue
San José CA 95129(US)

(74) Representative: Schaumburg, Thoenes &
Englaender
Mauerkircherstrasse 31 Postfach 86 07 48
D-8000 München 80(DE)

(54) **Head for attachment to a robot to pick up articles.**

(57) A head mechanism (21) for attachment to a
robot arm (19) inluding a base member (30) attached
to the arm to be rotatable therewith, a plurality of
radially extending gripper mechanisms (21) attached
to the base member (30), arranged about the axis of
rotation of the robot arm (19) each gripper mecha-
nism (21) including a gripper body member (50)
pivotally attached to the base member (30), and
actuator (42) for pivoting the body member (50)
between first and second positions, and a gripper
finger assembly (51) attached to the body member
for manipulating articles.

FIG-3

EP 0 302 475 A1

## Head for Attachment to a Robot to Pick Up Articles

This invention relates to a mechanism for attachment to a robot head to enable the robot to pick up or manipulate articles such as electronic components and place them in specific locations such as on a printed circuit board.

Devices of the kind mentioned must be able to pick up articles that are small and delicate and move those articles to predetermined locations within fractions of millimeters in accuracy. Additionally, such mechanisms must be capable of handling more than one type of component and, in order to save time, should be able to handle several different components at once such that each mechanism can be shifted into an operative position for picking up a component and when not in use, be out of the way to make room for another mechanism to function. Further, the mechanism must be made to work in conjunction with the capabilities of the robot and make use of all of the robotic functions available.

It is the primary object of the present invention to provide an improved mechanism for attachment to a robot for transporting, placing and manipulating articles.

A parts manipulator comprised of a head mechanism for attachment to the rotatable mount of a robot arm and including a base member attached directly to the mount to be rotatable therewith about a vertical axis and pivotally supporting a circumferential array of gripper mechanisms, each including a gripper finger portions, an actuator for indeputly pivoting the gripper portions of a selected gripper mechanism between two positions, side gripper fingers operable to move relative to each other and pick up and manipulate articles. The gripper finger portions are pivoted by the actuator from a first retracted up position with the fingers out of the way to a second operative down position for picking up and manipulating articles while being generally positioned by the robot arm. A downward facing camera lens centrally located between the gripper mechanisms enables viewing of the gripper finger portions of any of the gripper mechanisms, when in the operative down position.

Various advantages of the present invention will become apparent upon reading the following specification and by reference to the drawings in which:

Figur 1 is a perspective view of a robotic mechanism with which the subject invention is used;

Figur 2 is an enlarged side view showing the mechanism attached to the robot arm and in the retracted position;

Figur 3 is an enlarged side view, partially in cross section, of the mechanism in the operative position;

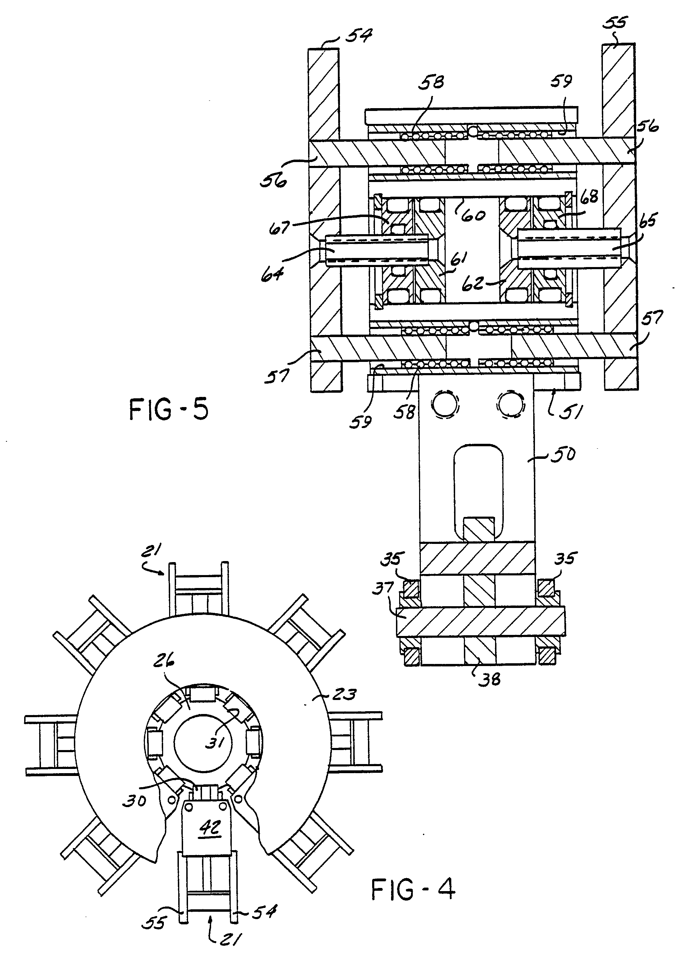

Figur 4 is a view, partially cut away, along the line 4-4 of Figure 1; and

Figur 5 is an enlarged cross sectional view along the line 5-5 of figure 2 showing the gripper mechanism.

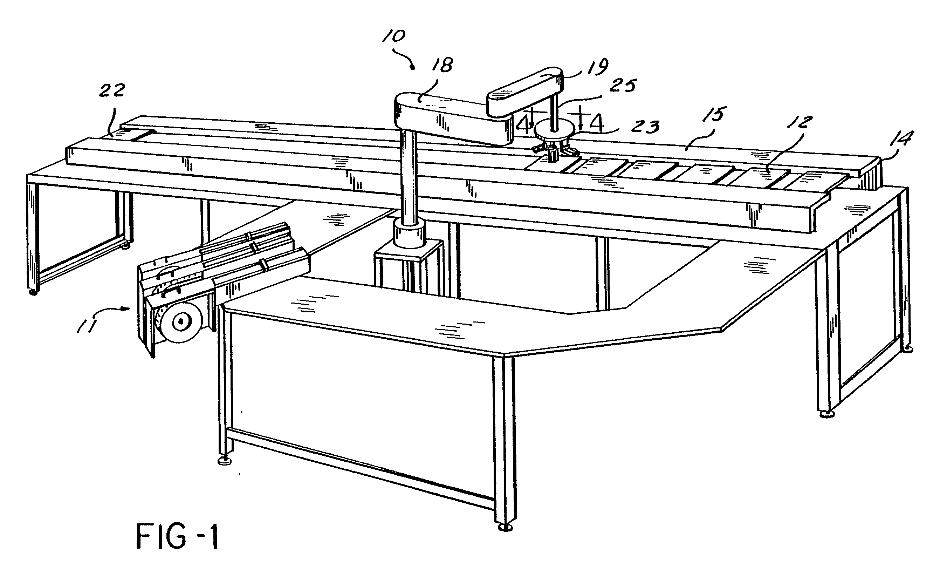

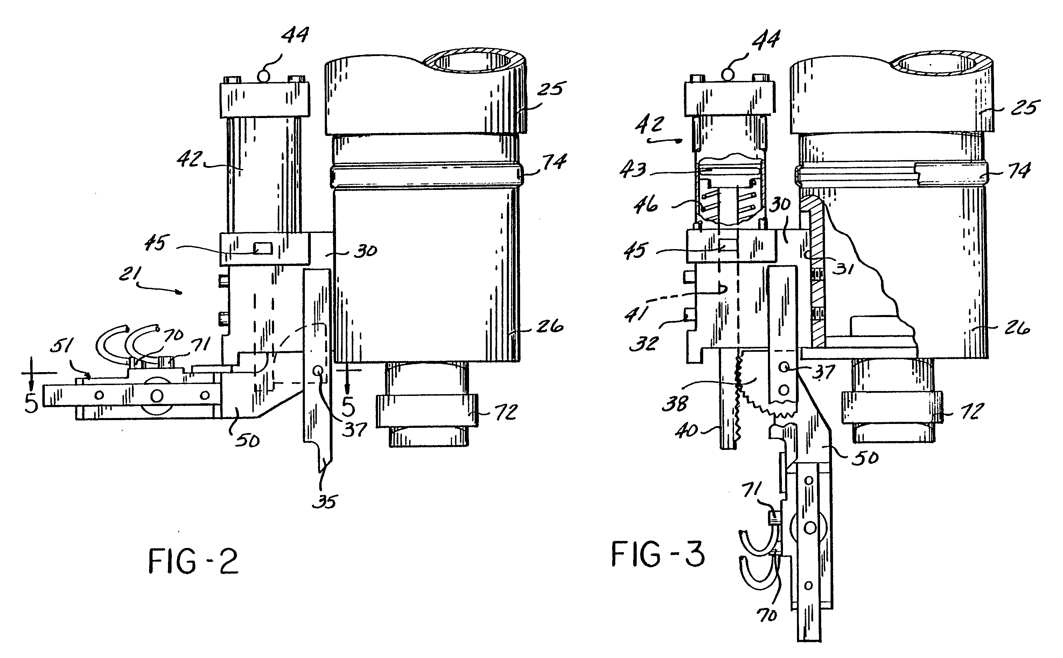

Figure 1 is a typical installation wherein the parts manipulator of the subject invention can be used. Shown therein is a robot 10 for feeding parts from feeder stations 11 to printed circuit boards 12 positioned on a conveyor 14. As the conveyor moves the printed circuit boards to the position 15, the robot shifts the arms 18 and 19 to move the head 20 to a position first to pick up components with a gripper mechanism 21 and thereafter to place those components into the printed circuit boards. After the printed circuit boards are loaded, they are moved to the off loading station 22. While there are other uses for the invention, one primary use is in conjuction with the robot mechanism just described. The robot includes a quill 25 extending vertically downward from the arm 19 to which is attached a printed circuit board 23 and in which is positioned a mount 26 (Figures 2 and 3) which can be rotated and precisely positioned.

In accordance with the present invention, a plurality of head mechanisms or gripper heads 21 are positioned around the mount 26. These gripper heads can be actuated to move between a first up and retracted position (Figure 2) extending transversely, normal to the axis of rotation of the arm 19 and mount 26 to a second, down and operative position (Figure 3) extending parallel to the axis of rotation of the arm 19 and mount 26. Thus with the gripper head in the first position it can be utilized to manipulate or grasp articles from a vertical stack, but usually is placed in this position so that a single gripper head extends downward and can be maneuvered as desired. With the gripper head in the second position, it extends downward for functioning below the mount. Thus by shifting one or more of the gripper heads to either the first or second position, manipulations can be effected as programmed.

Each gripper head comprises a base member 30 adapted to be fixed to the flat 31 on the mount 26 by screws 32. In the embodiment shown, there are eight flats formed, all equally spaced around the mount. Fixed to each side of the base is a standard 35. Through aligned openings in the standards a pin 37 extends to pivotally support a segment pinion gear 38. Interfitting with the segment pinion gear 38 is a rack 40 extending through an opening 41 in the base and fixed to the actuator piston 43 of an air driven cylinder 42. Thus as the cylinder is energized by air from a supply (not shown) and passed through the fitting 44, the rack 40 is driven downward into the position shown in Figure 3, pivoting the segment pinion gear 38 in a counter clockwise direction from a first position shown in Figure 2 to a second position shown in Figure 3. Pressured air supplied to the fitting 45 returns the actuator to the upward position. A spring 46 assures that the actuator piston 43 always returns to the position shown in Figure 2 when no pressured air is supplied or air is lost to the gripper head.

Fixed to the segment pinion gear is a gripper body 50 provided to support the gripper finger portions 51. These gripper finger portions 51 comprise a pair of gripper fingers 54 and 55. Each is supported on a pair of guide rods 56 and 57. The guide rods are each supported in a ball cage bearing 58 which rides in the ground cylinders 59.

To actuate the fingers 54 and 55 there is provided the cylinder 60 in which are positioned the opposing pistons 61 and 62 fixed by the piston rods 64 and 65 to the fingers, respectively. Rod seals 67 and 68 seal the outer ends of the cylinder 60 around the piston·rods. By making the piston rod 64 slightly smaller, the finger 54 is always actuated with greater force when pressured fluid is supplied to the cylinder 60 thereby making the finger 54 the reference finger. Pressured fluid is supplied and exhausted through the fittings 70 and 71 (Figure 2).

From the foregoing it is apparent that by the proper energization of the robot, the head mechanism can be positioned for use of a selected one of the gripper mechanisms 61. The gripper mechanisms 61 are also positioned by rotation of the mount 26 about the axis of the arm 19. By energization of the actuator 42 the gripper finger portions 51 of each of the gripper mechanisms 61 can be actuated downward as desired while the other can be left in the raised position out of the way. A camera lens 72 positioned at the end of the mount central to the gripper mechanisms allows for a comparison of the actual image detected to a recorded image through electronic components (not shown) for precise positioning of the gripper mechanisms. Additionally, a force sensor 74 can be employed to indicate forces on the quill for more precise manipulation of the gripper mechanisms.

## Claims

1. A head mechanism for attachment to a robot arm for manipulating articles wherein the arm can be moved vertically and horizontally and includes a mount that can be rotated about an axis of rotation, said head mechanism comprising:
a base member;
means attaching said base member to said mount;
a gripper body member;
means pivotally attaching said body member to said base member allowing said body member to pivot between first and second positions;
an actuator attached to said base member and connected to pivot said body member between said first and second positions; and
a pair of fingers fixed to said body member for manipulating articles.

2. A head mechanism as defined in claim 1 wherein said first and second positions comprise a first position with the body member extending normal to the shaft axis of rotation and a second position extending parallel to said axis of rotation.

3. A head mechanism as defined in claim 1 or 2 including an operator fixed to said body member and said fingers for moving said fingers relative to each other.

4. A head mechanism as defined in claim 3 wherein said operator comprises a piston rod fixed to each finger and mounted in a common cylinder; and
a pressure fluid source connected to supply pressured fluid to said cylinder for actuating said fingers.

5. A head mechanism as defined in claim 4 wherein one piston rod is larger than the other to cause one finger to be moved with greater force than the other finger thereby to establish a reference finger.

6. A head mechanism as defined in any one of claims 1 to 5 including a lens fixed to said mount for guiding said arm to position said head mechanism fingers.

7. A parts manipulator comprising:
an arm (19) having a portion (25) thereof mounted for rotation about an axis;
a plurality of gripper mechanisms (21) mounted to said arm portion (25) to be rotated therewith about said axis, said gripper mechanisms (21) arrayed circumferentially spaced about said axis;
each of said gripper mechanisms (21) including relatively movable gripper finger portions (51) and means (60, 61, 62, 64, 65) for selectively operating said gripper finger portions so as to grip a part; a plurality of mounting means (37, 50) each mounting said gripper finger portions (51) of a respective one of said gripper mechanisms (21) to be movable between an operative position and a retracted position, said gripper finger portions (51) in said retracted position moved away from said axis of rotation;

actuation means (42) associated with each of said gripper mechachnisms (21) operable to independently actuate a selected gripper mechanism (21) by moving the gripper finger portions (51) of said selected gripper mechanism (21) to the operative position, whereby any one of said gripper mechanisms (21) is available for handling of a part upon actuation by said actuation means (42).

8. The parts manipulator according to claim 7 wherein said mounting means (37, 50) comprises a pivotal mounting (37) of said gripper finger portions (51) to be swingable between said operative position and said retracted position.

9. The parts manipulator according to claim 7 or 8 further including a downwardly facing camera lens means (72) centrally located between said plurality of gripper mechanisms (21), positioned to view the space adjacent any of said gripper finger portions (51) when in the operative down position to thereby enable viewing of parts gripped by any of said gripper mechanisms (21) having gripper finger portions (51) in said operative down position.

10. The parts manipulator according to claim 7, 8 or 9 wherein eight gripper mechanisms (21) are arrayed about said rotation axis, arrayed in oppositely positioned pairs.

11. The parts manipulator according to any one of claims 7 to 10 wherein said actuating means (60) further including spring retraction means (51) causing each of said gripper finger portions (51) to rerturn to said retracted position whenever said gripper finger portions (51) are not urged to said operative position.

12. The parts manipulator according to any one of claims 7 to 11 wherein said arm portion (25) is rotatable about a vertical axis, and wherein said mounting means (37, 50) positions said gripper finger portions to be movable downwardly in moving from said retracted to said operative position.

13. The parts manipulator according to claim 12 wherein each of said gripper finger portions (51) are pivotably mounted by its respective mounting means (37, 50) to be swingable from said operative position parallel to said axis of rotation of said arm portion (25) to a position extending transversely to said axis of rotation of said arm portion (25).

FIG -1

EP 0 302 475 A1

FIG-2

FIG-3

EP 0 302 475 A1

FIG - 5

FIG - 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | DE-A-3 543 335 (BLACK & DECKER) * Column 8, lines 21-35; claims 1-3 * | 1-3 | B 25 J 15/02 |
| Y | | 4 | B 25 J 17/02 |
| A | | 8,12,13 | B 25 J 19/02 |
| | --- | | |
| Y | GB-A-2 041 262 (ASEA) * Page 1, lines 72-94 * | 4 | |
| | --- | | |
| A | EP-A-0 162 439 (ZAYTRAN) * Abstract * | 4 | |
| | --- | | |
| A | US-A-3 007 097 (SHELLEY) * Column 3, lines 8-33 * | 6,7,9 | |
| | --- | | |
| A | EP-A-0 139 857 (ASEA) * Abstract * | 7 | |
| | --- | | |
| A | US-A-4 437 114 (LARUSSA) * Abstract * | 6 | |
| | ----- | | |

TECHNICAL FIELDS
SEARCHED (Int. Cl.4)

B 25 J

The present search report has been drawn up for all claims

| Place of search | Date of completion of the search | Examiner |
|---|---|---|
| THE HAGUE | 12-10-1988 | LAMMINEUR P.C.G. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document